# EUROPÄISCHE PATENTSCHRIFT

(11) **EP 3 602 786 B1**
(45) Veröffentlichungstag und Bekanntmachung des Hinweises auf die Patenterteilung: **11.05.2022**
(21) Anmeldenummer: 18710434.4
(22) Anmeldetag: 08.03.2018
(51) Int. Cl.: H03K 17/96

(54) **HAUSHALTSGERÄT MIT GEGEN ELEKTROMAGNETISCHE STÖRUNGEN ABGESCHIRMTEM KAPAZITIVEM TOUCHSCREEN UND VERFAHREN ZU SEINER HERSTELLUNG**
HOME APPLIANCE COMPRISING A CAPACITIVE TOUCH SCREEN SHIELDED FROM ELECTROMAGNETIC INTERFERENCE, AND METHOD FOR MANUFACTURING SAME
APPAREIL ÉLECTROMÉNAGER COMPORTANT UN ÉCRAN TACTILE CAPACITIF BLINDÉ CONTRE LES INTERFÉRENCES ÉLECTROMAGNÉTIQUES ET PROCÉDÉ POUR LE RÉALISER

(30) Priorität: 22.03.2017 DE 102017204771
(43) Veröffentlichungstag der Anmeldung: 05.02.2020
(73) Patentinhaber: BSH Hausgeräte GmbH, 81739 München (DE)
(72) Erfinder: LUGAUER, Manuel, 93173 Wenzenbach (DE); GERHARDT, Martin, 93059 Regensburg (DE); FELDMEIER, Rudolf, 93128 Regenstauf / Eitlbrunn (DE); STROBEL, Karl-Heinz, 93192 Wald (DE)
(86) Internationale Anmeldenummer: PCT/EP2018/055725
(87) Internationale Veröffentlichungsnummer: WO 2018/172085

(56) Entgegenhaltungen:
- DE-A1-102014 213 903
- US-A1- 2013 257 801

## Beschreibung

Die Erfindung betrifft ein Haushaltsgerät mit einem gegen elektromagnetische Störungen abgeschirmten kapazitiven Touchscreen. Die Erfindung betrifft insbesondere ein Haushaltsgerät mit einem Gerätegehäuse und einer Bedienvorrichtung mit einem kapazitiven Touchscreen, umfassend Sensorelektroden. Die Erfindung betrifft außerdem ein Verfahren zur Herstellung einer bevorzugten Ausführungsform dieses Haushaltsgeräts.

Haushaltsgeräte mit einem kapazitiven Touchscreen sind gut bekannt.

So beschreiben die Veröffentlichungen DE 10 2011 081 331 A1 und WO 2013/026734 A1 ein Haushaltsgerät mit einer berührungssensitiven Bedien- und Anzeigeeinrichtung, welche eine Anzeigeeinheit zur Anzeige von Bedieninformationen und ein transparentes Trägerteil aufweist, an welchem zumindest eine kapazitive Sensorelektrode als Teil eines Berührungskondensators angeordnet ist, welche in Überlappung mit der Anzeigeeinheit und in Überlappung mit einer berührungssensitiven Betätigungsfläche der Bedien- und Anzeigeeinrichtung angeordnet ist.

Die Veröffentlichung DE 10 2011 077 902 A1 beschreibt eine kapazitive Bedien- und Anzeigeeinrichtung für ein Haushaltsgerät, mit einem Anzeigefenster mit einer berührungsempfindlichen Bedienfläche, wobei am Anzeigefenster ein Anzeigesymbol angebracht ist, mit mindestens einem Leuchtelement zur Abgabe von Licht zum Hinterleuchten des Anzeigesymbols, und mit einer kapazitiven Sensorelektrode als Teil eines Berührungskondensators, welche in einem Abstand zur Bedienfläche angeordnet sind, so dass beim Berühren der Bedienfläche eine Kapazität des Berührungskondensators veränderbar ist, wobei die Sensorelektrode an einer Leiterplatte angeordnet ist und zwischen der Bedienfläche und der Sensorelektrode ein Element angeordnet ist, welches aus einem elastischen, elektrisch isolierenden Material ausgebildet ist.

Bei den kapazitiven Touchscreens ist es prinzipiell auch bekannt, eine Abschirmung gegenüber elektromagnetischer Strahlung vorzunehmen.

So beschreibt die Veröffentlichung EP 1 953 915 B1 ein Haushaltsgerät mit einem kapazitiven Inkrementalgeber, welcher zumindest drei Gruppen von einzelnen Sensorflächen hat, wobei alle Sensorflächen derselben Gruppe miteinander elektrisch leitend verbunden sind und die Sensorflächen von einer elektrisch isolierenden Abdeckplatte abgedeckt sind und Teile von Kondensatoren mit durch Berührung der Abdeckplatte veränderlicher Kapazität sind. An jede Gruppe ist ein Spannungssignal, insbesondere ein Taktsignal, anlegbar. In einer Ausführungsform weisen die Sensorflächen jeweils eine aktive Abschirmung auf, welche durch eine Abschirmfläche gebildet ist, an der zeitgleich mit den Sensorflächen das Taktsignal anliegt.

Allerdings können durch elektromagnetische Störungen, die leitungsgebunden oder feldgebunden auftreten können, Berührungssignale (auch als "Touchereignisse" bezeichenbar) auch ohne eine Berührung aufgrund einer Bedienung durch einen Benutzer des Haushaltsgerätes ausgelöst werden, was zu einer ungewollten Bedienung des Haushaltsgerätes führen kann. Es besteht daher ein Interesse an einer weiteren Verbesserung der Abschirmung von kapazitiven Touchscreens gegenüber elektromagnetischen Störungen.

Dabei ist zu berücksichtigen, dass eine verbesserte Abschirmung gegenüber elektromagnetischen Störungen insbesondere in solchen Fällen von Interesse ist, in denen die Spannungsversorgung der Elektronik des Haushaltsgerätes mit einem Bezug zum elektrischen Versorgungsnetz, d.h. einem Netzbezug, erfolgt. In solchen Fällen liegt keine mit Mehrkosten verbundene galvanische Trennung vor, so dass der Elektronik-Ground des Haushaltsgerätes nicht direkt mit dem Gerätegehäuse verbunden werden kann.

Die Veröffentlichung DE 10 2014 213 903 A1 offenbart eine elektronische Benutzerschnittstelle, aufweisend eine Gerätefrontblende mit einer Innenseite, wenigstens ein an der Gerätefrontblende angeordnetes Ein- und/oder Ausgabemittel, sowie wenigstens ein Blendenteil, das eine elektrisch leitende Oberfläche aufweist, wobei hinter der Innenseite der Gerätefrontblende eine elektronische Baugruppe angeordnet ist und eine die elektronische Baugruppe von dem wenigstens einen elektrisch leitenden Blendenteil gegen elektrische und/oder magnetische Felder abschirmende Abschirmvorrichtung. Die Abschirmvorrichtung erstreckt sich im Wesentlichen lediglich in einer Ebene zwischen der Innenseite der Gerätefrontblende und der elektronischen Baugruppe, wobei die Abschirmvorrichtung eine umlaufende Außenkante aufweist. Die Figur 4 zeigt denn auch eine flache Abschirmvorrichtung, an welcher Haken 14 lediglich zur Befestigung bzw. zur Herstellung einer elektrisch leitenden Verbindung der Abschirmvorrichtung mit dem elektrisch leitenden Blendenteil dienen.

Die Veröffentlichung US 2013/0257801 A1 beschreibt einen Berührungssensor, umfassend ein Panelsubstrat, an welches ein Operationsobjekt einschließlich eines Fingers von der vorderen Oberflächenseite davon in die Nähe kommt, und ein Detektionsmuster, das als ein leitfähiges Muster direkt auf einer rückseitigen Oberfläche des Panelsubstrates gebildet ist, um eine Änderung in der Kapazität festzustellen. Gemäß Anspruch 3 ist ein Grundmuster (ground pattern) in der Peripherie des Detektionsmusters angeordnet. Dieses soll den Widerstand gegenüber von außen eintretendem Rauschen erhöhen und auch das Abstrahlen von Radiowellen von der Seite des Detektionsmusters unterdrücken.

Vor diesem Hintergrund war es Aufgabe der vorliegenden Erfindung, ein Haushaltsgerät mit einem kapazitiven Touchscreen bereitzustellen, das eine verbesserte Abschirmung gegenüber elektromagnetischen Störungen aufweist. Außerdem sollte ein Verfahren zur Herstellung dieses Haushaltsgeräts bereitgestellt werden.

Die Lösung dieser Aufgabe wird nach dieser Erfindung erreicht durch ein Haushaltsgerät sowie ein Verfahren zur Herstellung eines Haushaltsgerätes mit den Merkmalen der entsprechenden unabhängigen Patentansprüche. Bevorzugte Ausführungsformen des erfindungsgemäßen Haushaltsgeräts sowie des erfindungsgemäßen Verfahrens sind in den jeweiligen abhängigen Patentansprüchen aufgeführt. Bevorzugten Ausführungsformen des erfindungsgemäßen Haushaltsgeräts entsprechen bevorzugte Ausführungsformen des erfindungsgemäßen Verfahrens und umgekehrt, auch wenn dies hierin nicht explizit festgestellt ist.

Gegenstand der Erfindung ist somit ein Haushaltsgerät mit einem Gerätegehäuse und einer Bedienvorrichtung mit einem kapazitiven Touchscreen, umfassend Sensorelektroden, wobei der kapazitive Touchscreen durch eine sich in das Geräteinnere erstreckende, an den kapazitiven Touchscreen anschließende elektrisch leitfähige dreidimensionale Schirmstruktur gegen elektromagnetische Strahlung abgeschirmt ist, wobei die elektrisch leitfähige dreidimensionale Schirmstruktur mehrere Schirmelemente beinhaltet, die sich an den kapazitiven Touchscreen anschließen, so dass sie umlaufend um den kapazitiven Touchscreen über dessen Rand geführt sind, der als Faltkante ausgebildet ist, so dass eine sich in das Geräteinnere erstreckende Schirmstruktur gebildet werden kann. Im erfindungsgemäßen Haushaltsgerät ist das Gerätegehäuse im Allgemeinen metallisch. Die Sensorelektroden sind im Allgemeinen hinter einer Frontplatte angeordnet, so dass der kapazitive Touchscreen im Allgemeinen eine Frontplatte und hinter der Frontplatte, d.h. auf der einem Benutzer des Haushaltsgerätes abgewandten Seite der Frontplatte, angeordnete Sensorelektroden umfasst.

Die Form des kapazitiven Touchscreens ist nicht eingeschränkt, auch wenn hierin aus Gründen der Vereinfachung von einem im Wesentlichen flachen kapazitiven Touchscreen ausgegangen wird. Es können aber auch kapazitive Touchscreens mit einer von einer flachen Form abweichenden Form verwendet werden, welche beispielsweise konkav oder konvex gekrümmt sind.

In einer bevorzugten Ausführungsform enthält die elektrische leitfähige Schirmstruktur ein Metall und/oder ein elektrisch leitfähiges organisches Polymer.

Geeignete Metalle sind insbesondere Eisen (Stahl), Kupfer und Aluminium. Sofern ein Metall eingesetzt wird, ist Kupfer bevorzugt. Allerdings können auch elektrisch leitfähige organische Polymere eingesetzt werden wie z.B. Polyaniline, Polythiophene oder Polypyrrole, sofern diese über eine ausreichende elektrische Leitfähigkeit verfügen. Erfindungsgemäß beinhaltet die elektrisch leitfähige Schirmstruktur mehrere Schirmelemente, die sich an den kapazitiven Touchscreen anschließen, also umlaufend um den kapazitiven Touchscreen über dessen Rand geführt sind. Dabei dient der Rand des kapazitiven Touchscreens als Faltkante, so dass eine sich in das Geräteinnere erstreckende Schirmstruktur gebildet werden kann. Je nach Ausbildung und Anordnung der Schirmelemente, insbesondere auch dem Grad des Faltens der Schirmelemente gegenüber dem kapazitiven Touchscreen kann im erfindungsgemäßen Haushaltsgerät die elektrisch leitfähige Schirmstruktur offen oder geschlossen sein. Dabei kann eine geschlossene Schirmstruktur insbesondere als eine Wanne angesehen werden, deren Wände durch die Schirmelemente gebildet werden.

Die elektrisch leitfähige Schirmstruktur, insbesondere dessen Schirmelemente, kann vollflächig oder als Gitterstruktur ausgeführt sein. Außerdem kann die Schirmstruktur prinzipiell auch Unterbrechungen aufweisen. Dies kann beispielsweise dadurch realisiert sein, dass Schirmelemente nicht umlaufend, d.h. mit Unterbrechungen, um den kapazitiven Touchscreen angeordnet sind. Schließlich können Schirmelemente auch unterschiedlich breit und lang sein. Dabei muss die Breite eines Schirmelementes nicht unbedingt der Länge einer Seite eines rechteckigen Touchpanels entsprechen.

In einer besonders bevorzugten Ausführungsform des Haushaltsgerätes bildet der kapazitive Touchscreen im Wesentlichen ein Rechteck, an dessen vier Seiten sich die Schirmelemente anschließen.

Hierbei bedeutet "im Wesentlichen" insbesondere, dass auch Abweichungen in Hinblick auf Formen wie beispielsweise eine Trapezform möglich sind und insbesondere auch abgerundete Ecken oder gebogene Seiten möglich sind, sofern die Erfindung realisiert werden kann.

Schließlich ist es erfindungsgemäß bevorzugt, dass die Schirmelemente als Rechtecke ausgebildet sind. Dabei können die Schirmelemente an den Seiten, insbesondere an den kurzen Seiten, Flügelelemente aufweisen, die in der Schirmstruktur zu einer Überlappung der Schirmelemente bzw. der Vermeidung von Öffnungen zwischen Schirmelementen in der Schirmstruktur beitragen können.

Die elektrisch leitfähige Schirmstruktur und der Touchscreen bilden vorzugsweise einen Winkel α im Bereich von 10° bis 90°, vorzugsweise 45° bis 90° und besonders bevorzugt 70° bis 90°.

Sind die im Allgemeinen vorhandenen Schirmelemente als Rechtecke ausgebildet und in der Schirmstruktur um 90° gefaltet, so würde sich beispielsweise mit einer GND-Plane der Leiterplatte ein Schirm-Gehäuse ergeben.

In einer ganz besonders bevorzugten Ausführungsform des erfindungsgemäßen Haushaltsgerätes weist es ein Folienelement auf, das die Sensorelektroden des kapazitiven Touchscreens und/oder die elektrisch leitfähige Schirmstruktur enthält. Dabei können sich Sensorelektroden und/oder elektrisch leitfähige Schirmstruktur nur auf einer Seite einer einzigen Folie oder eines einzigen Folienlaminats befinden, vorzugsweise befinden sich aber sowohl Sensorelektroden als auch Schirmstruktur zwischen zwei Folien, insbesondere Einzelfolien. Sofern das Folienelement die Sensorelektroden enthält, wird es hierin auch als Touchfolie bezeichnet.

Bei dieser Ausführungsform enthält das Folienelement vorzugsweise in einem ersten Folienteil die Sensorelektroden und in einem zweiten Folienteil die elektrisch leitfähige Schirmstruktur. Auch hierbei kann die elektrisch leitfähige Schirmstruktur im zweiten Folienteil vollflächig oder als Gitterstruktur ausgebildet sein. Vorzugsweise ist dabei die elektrisch leitfähige Schirmstruktur im zweiten Folienteil vollflächig ausgebildet und stellt beispielsweise eine massive Kupferfolie zwischen zwei Einzelfolien dar.

Die Touchfolie ist eine kapazitive Touchfolie, die somit mindestens eine Sensorelektrode umfasst, welche durch Annäherung und/oder Berührung durch eine externe Eingabeeinheit, z.B. einen Finger, ein durch Änderungen der elektrischen Kapazität hervorgerufenes elektrisches Signal erzeugen kann.

Besonders bevorzugt weist die Touchfolie ein Koordinatennetz aus Sensorelektroden auf. Zwischen den Sensorelektroden befindet sich dabei in der Regel ein isolierendes Material, ein sogenanntes Dielektrikum. Erfindungsgemäß kann das Koordinatennetz aus Elektroden durch das Auftragen eines strukturierten, elektrisch leitfähigen Materials ausgebildet werden. Die Strukturierung kann vielfältige Formen von einfachen geometrischen Formen, wie Kreisen, Rechtecken, usw., bis hin zu komplizierten unregelmäßigen Formen aufweisen, aber auch Linien in X- und Y-Richtung sind möglich. Das elektrisch leitfähige Material ist vorzugsweise transparent, beispielsweise Indium-Zinnoxid (ITO). Allerdings können auch an sich nicht transparente Materialien wie z.B. Kupfer verwendet werden. In solchen Fällen kann das nicht transparente Material in sehr geringer Dicke und/oder als Netzstruktur in der Touchfolie bzw. im kapazitiven Touchscreen verwendet werden. Besonders bevorzugt können aber auch transparente und leitfähige Lacke und/oder Kleber verwendet werden. Letztere haben insbesondere den Vorteil einer einfacheren Aufbringung auf geformte Oberflächen, beispielsweise konvexe oder konkave Oberflächen, ohne Einbußen in der Funktionalität. Zudem sind leitfähige Lacke und/oder Kleber häufig auch kostengünstiger.

Allerdings kann beispielsweise auch eine Anordnung von Touchelektroden aus Kupfer auf einer Kunststofffolie oder vorzugsweise zwischen zwei Kunststofffolien eingesetzt werden. Eine solche Touchfolie kann ebenfalls sehr breit eingesetzt werden.

Die Touchfolie ist in der Regel mit einer Auswerteelektronik verbunden, welche notwendig ist, um ein durch Änderungen der elektrischen Kapazität hervorgerufenes elektrisches Signal infolge einer Annäherung und/oder Berührung von Sensorelektroden durch eine externe Eingabeeinheit zu erfassen. Der Begriff "Auswerteelektronik" umfasst dabei in der Regel elektronische Bauteile, Leiterbahnstrukturen, Lötverbindungen und ggf. weitere Komponenten. Die Auswerteelektronik ist im Allgemeinen mit einer Steuereinrichtung des Haushaltsgeräts verbunden.

Die elektrisch leitende Schirmstruktur ist im Allgemeinen mit einer Spannungsquelle verbunden. Dies kann auf unterschiedliche Weise realisiert sein. So kann in einer bevorzugten Ausführungsform des Haushaltsgerätes eine elektrische Anbindung der Schirmstruktur über einen Anschluss erfolgen, über den auch die Anbindung des kapazitiven Touchscreens an eine Auswerteelektronik erfolgt.

Es kann also beispielsweise eine Touchfolie mit einer Auswerteelektronik über den gleichen Anschluss verbunden sein wie die Anbindung der Schirmstruktur an eine Spannungsquelle. Alternativ könnte die elektrische Anbindung der Schirmstruktur auf die Auswerte-Elektronik auch über einen gesonderten Touchfolien-Anschluss oder über eine Klammer oder Schraube erfolgen. Falls die elektrisch leitfähige Schirmstruktur mit Unterbrechung(en) auf der Touchfolie aufgebracht ist, so dass keine umlaufende Schirmstruktur gegeben ist, wäre ein zusätzlicher elektrischer Anschluss an der Schirmstruktur erforderlich.

Erfindungsgemäß kann die elektrisch leitfähige Schirmstruktur auf unterschiedlichen Potentialen liegen. Es kann sich dabei um ein vorgegebenes Wechselsignal, insbesondere ein Taktsignal, handeln oder aber es kann ein vorgegebener fester Spannungspegel sein.

Die Anordnung des Touchscreens am Haushaltsgerät ist nicht besonders eingeschränkt. Vorzugsweise ist jedoch der Touchscreen in einem Winkel von 10° bis 45°, bezogen auf eine vertikale Achse auf einer Grundfläche des Haushaltsgerätes, angebracht.

Ein optional verwendetes Folienelement ist vorzugsweise über eine Klebeschicht an einer Frontplatte des kapazitiven Touchscreens angebracht.

Es ist erfindungsgemäß überdies bevorzugt, dass die Bedienvorrichtung ein Kunststoffgehäuse enthält, welches den kapazitiven Touchscreen und die elektrisch leitfähige Schirmstruktur derart umfasst, dass die elektrisch leitfähige Schirmstruktur das im Allgemeinen metallische Gerätegehäuse nicht berührt. Über eine kapazitive Kopplung zu einem metallischen Gerätegehäuse können elektromagnetische Störungen kapazitive gegen Erde abgeleitet werden.

Unter einem Haushaltsgerät wird hierin vorzugsweise ein Gerät verstanden, das zur Behandlung von Haushaltsgegenständen ausgebildet ist, z.B. von Wäschestücken, Geschirr und Lebensmitteln. Es kann ein Haushaltsgroßgerät sein, wie beispielsweise eine Waschmaschine, ein Waschtrockner, eine Geschirrspülmaschine, ein Gargerät, eine Dunstabzugshaube, ein Kältegerät, eine Kühl-Gefrier-Kombination oder ein Klimagerät. Es kann aber auch ein Haushaltskleingerät sein, wie beispielsweise ein Kaffee-Vollautomat oder eine Küchenmaschine. Ganz besonders bevorzugt ist das Haushaltsgerät ein wasserführendes Haushaltsgerät, das ausgewählt ist aus der Gruppe bestehend aus Waschmaschine, Waschtrockner und Trockner.

Gegenstand der Erfindung ist außerdem ein Verfahren zur Herstellung eines Haushaltsgerätes mit einem Gerätegehäuse, einer Bedienvorrichtung mit einem kapazitiven Touchscreen, umfassend Sensorelektroden, wobei der kapazitive Touchscreen durch eine sich in das Geräteinnere erstreckende, an den kapazitiven Touchscreen anschließende elektrisch leitfähige dreidimensionale Schirmstruktur gegen elektromagnetische Strahlung abgeschirmt ist, und das Haushaltsgerät ein Folienelement aufweist, das die Sensorelektroden des kapazitiven Touchscreens und die elektrisch leitfähige Schirmstruktur enthält, wobei die elektrisch leitfähige dreidimensionale Schirmstruktur mehrere Schirmelemente beinhaltet, die sich an den kapazitiven Touchscreen anschließen, so dass sie umlaufend um den kapazitiven Touchscreen über dessen Rand geführt sind, der als Faltkante ausgebildet ist, so dass eine sich in das Geräteinnere erstreckende Schirmstruktur gebildet werden kann, umfassend die Schritte:
(a) Bereitstellen eines Folienelementes, das die Sensorelektroden des kapazitiven Touchscreens und die elektrisch leitfähige Schirmstruktur enthält;
(b) Anbringen des Folienelementes an einer Frontplatte des kapazitiven Touchscreens;
(c) Einstellen eines Winkels α zwischen der elektrisch leitfähigen dreidimensionalen Schirmstruktur und dem Touchscreen im Bereich von 10° bis 90°, vorzugsweise 45° bis 90° und besonders bevorzugt 70° bis 90 °, wobei das Einstellen des Winkels α zwischen der elektrisch leitfähigen Schirmstruktur und dem Touchscreen durch ein Falten der Schirmelemente, die um den kapazitiven Touchscreen herum angeordnet sind, entlang des Randes des kapazitiven Touchscreens erfolgt;
(d) Einbringen von kapazitivem Touchscreen und elektrisch leitfähiger Schirmstruktur in das Gerätegehäuse.

Im Schritt (c) erfolgt das Einstellen des Winkels α zwischen der elektrisch leitfähigen Schirmstruktur und dem Touchscreen durch ein Falten von Schirmelementen, die um einen kapazitiven Touchscreen herum angeordnet sind, entlang des Randes des kapazitiven Touchscreens. Liegt ein kapazitiver Touchscreen beispielsweise in der Form eines Rechteckes vor und sind Schirmelemente als Rechtecke um den kapazitiven Touchscreen herum ausgebildet, ergibt ein Falten der Schirmelemente um einen Winkel α von 90° eine Schirmstruktur, die beispielsweise mit einer GND-Plane der Leiterplatte ein Schirm-Gehäuse bildet.

Die Erfindung hat zahlreiche Vorteile. Durch die erfindungsgemäße Ausgestaltung des Haushaltsgerätes kann die Bedienung sicherer ausgestaltet werden und durch elektromagnetische Störungen verursachte Touchsignale noch wirksamer vermieden werden. Die erfindungsgemäß vorgesehene Schirmstruktur schirmt leitungsgebundene und feldgebundene Störungen ab, die ansonsten zu Selbstauslösern (ungewollte Auslöser von Touchsignalen) oder erhöhtem Rauschen, d.h. einem geringeren Signal-Rausch-Abstand, führen könnten. Dadurch kann der Signal-Rausch-Abstand erhöht werden. Die Erfindung ermöglicht in bevorzugten Ausführungsformen eine besonders einfache und damit auch kostengünstige Realisierung, indem bei Verwendung einer aus zwei Folienanteilen bestehenden Touchfolie auf einfache Weise durch Falten des zweiten Folienteils, welcher Schirmelemente bildet, um das erste Folienteil, welches den kapazitiven Touchscreen bildet und damit die Sensorelektroden aufweist, eine elektrisch leitfähige Schirmstruktur gebildet werden kann. Das einfache Prinzip des Umbiegens von seitlichen Schirmflügeln erfordert keine besonderen und teuren Fertigungsschritte.

Jedenfalls kann auf eine galvanische Trennung der Versorgungsspannung, welche beispielsweise höhere Mehrkosten als eine zusätzliche Schirmstruktur verursachen würde, verzichtet werden.

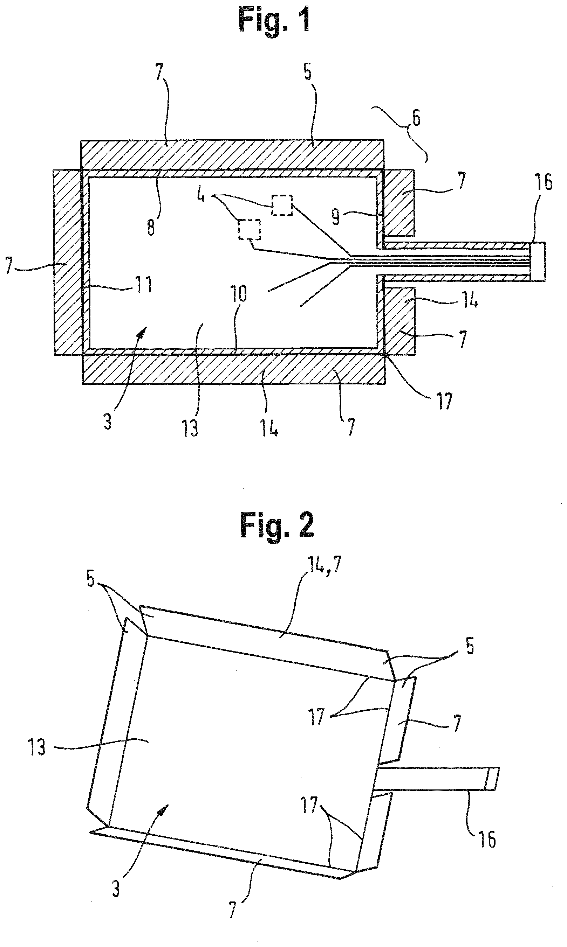

Weitere Einzelheiten der Erfindung ergeben sich aus der nachfolgenden Beschreibung von erfindungswesentlichen Teilen eines ansonsten nicht näher gezeigten Haushaltsgerätes. Hierbei wird Bezug genommen auf die Figuren 1 bis 3.

Fig. 1 zeigt in einer Draufsicht einen kapazitiven Touchscreen mit den Schirmelementen einer elektrisch leitfähigen Schirmstruktur vor dem Falten der Schirmelemente zur Ausbildung der elektrisch leitfähigen Schirmstruktur, wobei beide in einem Folienelement 6 enthalten sind.

Fig. 2 zeigt in einer perspektivischen Ansicht einen kapazitiven Touchscreen mit den Schirmelementen einer elektrisch leitfähigen Schirmstruktur, welche um den kapazitiven, hier rechteckig ausgebildeten, Touchscreen gebildet ist, wobei die Schirmelemente einen Winkel α kleiner 90°mit dem Touchscreen bilden.

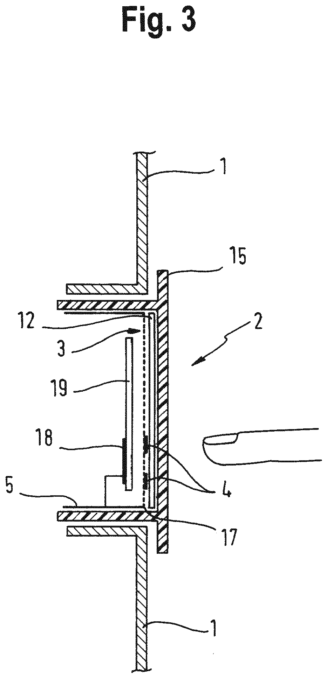

Fig. 3 zeigt eine seitliche Schnittansicht durch eine Bedienvorrichtung eines ansonsten nicht näher gezeigten Haushaltsgerätes, wobei die Bedienvorrichtung einen kapazitiven Touchscreen, umfassend Sensorelektroden, sowie eine sich in das Geräteinnere erstreckende, an den kapazitiven Touchscreen anschließende elektrisch leitfähige Schirmstruktur aufweist.

In der Fig. 1 ist in einer Draufsicht ein kapazitiver Touchscreen 3 mit Sensorelektroden 4 sowie mit den Schirmelementen 7 einer elektrisch leitfähigen Schirmstruktur 5 vor dem Falten der Schirmelemente 7 zur Ausbildung der elektrisch leitfähigen Schirmstruktur 5 gezeigt, wobei beide in einem Folienelement 6 enthalten sind. Das Folienelement 6 weist einen ersten Folienteil 13 auf, in welchem sich der kapazitive Touchscreen 3 befindet, sowie einen zweiten Folienteil 14, in welchem sich die Schirmelemente 7 befinden. Die Schirmelemente 7 sind an den Seiten 8, 9, 10, und 11 des kapazitiven Touchscreens angebracht, der hier in Form eines Rechteckes ausgebildet ist. Die Sensorelektroden 4, von denen hier zwei durch gestrichelt gezeichnete Rechtecke angedeutet sind, sind über einen Anschluss 16, über den auch die Schirmelemente 7 mit dem Electronic Ground einer hier nicht gezeigten Platine verbunden sind, mit einer hier ebenfalls nicht gezeigten Auswerteelektronik für Berührungen des kapazitiven Touchscreens durch einen Benutzer verbunden.

17 bedeutet eine Faltlinie, um welche der zweite Folienteil 14, d.h. die Schirmelemente 7, gegenüber dem ersten Folienteil 13, d.h. dem kapazitiven Touchscreen 3, gefaltet werden kann, um eine dreidimensionale elektrisch leitfähige Schirmstruktur 5 zu bilden. Während der kapazitive Touchscreen 3 im Wesentlichen aus voneiander isolierten Sensorflächen besteht, bestehen die Schirmelemente 7 sowie ein kleiner benachbarter Teil im ersten Folienteil 13, durch Schraffieren hervorgehoben aus einer dünnen massiven Metallfolie, hier aus Kupfer.

Fig. 2 zeigt in einer perspektivischen Ansicht einen kapazitiven Touchscreen 3 mit den Schirmelementen 7 einer elektrisch leitfähigen Schirmstruktur 5, welche um den kapazitiven, hier rechteckig ausgebildeten, Touchscreen 3 gebildet ist, wobei die Schirmelemente 7 mit dem Touchscreen 3 einen Winkel α kleiner 90° bilden. 6 bedeutet ein Folienelement mit einem ersten Folienteil 13 und einem zweiten Folienteil 14.

17 bedeutet eine Faltlinie, um welchen die Schirmelemente 7 des zweiten Folienteils 14 gegenüber dem ersten Folienteil 13, d.h. dem kapazitiven Touchscreen 3, gefaltet werden können, um die dreidimensionale elektrisch leitfähige Schirmstruktur 5 zu bilden.

Hier nicht näher gezeigte Sensorelektroden sind über einen Anschluss 16, über den auch die Schirmelemente 7 mit dem Electronic Ground einer hier nicht gezeigten Platine verbunden sind, mit einer hier ebenfalls nicht gezeigten Auswerteelektronik für Berührungen des kapazitiven Touchscreens durch einen Benutzer verbunden.

Fig. 3 zeigt eine seitliche Schnittansicht durch eine Bedienvorrichtung 2 eines ansonsten nicht näher gezeigten Haushaltsgerätes, wobei die Bedienvorrichtung 2 einen kapazitiven Touchscreen 3, umfassend Sensorelektroden 4, sowie eine sich in das Geräteinnere erstreckende, an den kapazitiven Touchscreen 3 anschließende elektrisch leitfähige Schirmstruktur 5 aufweist.

Die Bedienvorrichtung 2 enthält ein Kunststoffgehäuse 15, welches den kapazitiven Touchscreen 3 und die elektrisch leitfähige Schirmstruktur 5 derart umfasst, dass die elektrisch leitfähige Schirmstruktur 5 das Gerätegehäuse 1, das hier ein metallisches Gerätegehäuse ist, nicht berührt. Im Inneren des Kunststoffgehäuses 15 ist eine Frontplatte, beispielsweise aus Glas oder einem transparenten Kunststoff wie Polymethylmethacrylat, angebracht. Auf einer dem Benutzer abgewandten Seite der Frontplatte 12 ist ein Folienelement 6 geklebt, in welchem bei der hier gezeigten Ausführungsform Sensorelektroden 4 aus Kupfer zwischen zwei hier nicht gezeigten Einzelfolien, z.B. aus PET, angeordnet sind.

17 bedeutet hier eine Faltlinie, die einen ersten Folienteil von einem die elektrisch leitfähige Schirmstruktur 5 bildenden zweiten Folienteil trennt. Die elektrische leitfähige Schirmstruktur 5 ist mit der elektronischen Erde 18 einer Platine 19 leitend verbunden.

Ein ausschnittsweise gezeigter Finger eines Benutzers zeigt, dass letztlich das Kunststoffgehäuse 15 berührt wird, um Touchsignale auszulösen.

### Bezugszeichen

- 1: Gerätegehäuse
- 2: Bedienvorrichtung
- 3: Kapazitiver Touchscreen
- 4: Sensorelektroden
- 5: elektrisch leitfähige Schirmstruktur
- 6: Folienelement
- 7: Schirmelement
- 8: Erste, lange Seite eines Rechteckes, welches der kapazitive Touchscreen bildet
- 9: Zweite, kurze Seite eines Rechteckes, welches der kapazitive Touchscreen bildet
- 10: Dritte, lange Seite eines Rechteckes, welches der kapazitive Touchscreen bildet
- 11: Vierte, kurze Seite eines Rechteckes, welches der kapazitive Touchscreen bildet
- 12: Frontplatte
- 13: Erster Folienteil (enthaltend die Sensorelektroden)
- 14: Zweiter Folienteil (enthaltend die elektrisch leitfähige Schirmstruktur)
- 15: Kunststoffgehäuse
- 16: Anschluss des kapazitiven Touchscreens bzw. der elektrisch leitfähigen Schirmstruktur
- 17: Faltlinie
- 18: Elektronische Erde (electronic ground)
- 19: PCB, Platine

## Patentansprüche

1. Haushaltsgerät mit einem Gerätegehäuse (1), einer Bedienvorrichtung (2) mit einem kapazitiven Touchscreen (3), umfassend Sensorelektroden (4), wobei der kapazitive Touchscreen (3) durch eine sich in das Geräteinnere erstreckende, an den kapazitiven Touchscreen (3) anschließende elektrisch leitfähige dreidimensionale Schirmstruktur (5) gegen elektromagnetische Strahlung abgeschirmt ist, wobei die elektrisch leitfähige dreidimensionale Schirmstruktur (5) mehrere Schirmelemente (7) beinhaltet, die sich an den kapazitiven Touchscreen (3) anschließen, so dass sie umlaufend um den kapazitiven Touchscreen (3) über dessen Rand geführt sind, der als Faltkante ausgebildet ist, so dass eine sich in das Geräteinnere erstreckende Schirmstruktur (5) gebildet werden kann.

2. Haushaltsgerät nach Anspruch 1, **dadurch gekennzeichnet, dass** die elektrische leitfähige dreidimensionale Schirmstruktur (5) ein Metall und/oder ein elektrisch leitfähiges organisches Metall enthält.

3. Haushaltsgerät nach Anspruch 2, **dadurch gekennzeichnet, dass** das Metall Kupfer ist.

4. Haushaltsgerät nach einem der Ansprüche 1 bis 3, **dadurch gekennzeichnet, dass** der kapazitive Touchscreen (3) im Wesentlichen ein Rechteck bildet, an dessen vier Seiten (8,9,10,11) sich die Schirmelemente (7) anschließen.

5. Haushaltsgerät nach Anspruch 4, **dadurch gekennzeichnet, dass** die Schirmelemente (7) als Rechtecke ausgebildet sind.

6. Haushaltsgerät nach einem der Ansprüche 1 bis 5, **dadurch gekennzeichnet, dass** es ein Folienelement (6) aufweist, das die Sensorelektroden (4) des kapazitiven Touchscreens (3) und/oder die elektrisch leitfähige dreidimensionale Schirmstruktur (5) enthält.

7. Haushaltsgerät nach Anspruch 6, **dadurch gekennzeichnet, dass** das Folienelement (6) in einem ersten Folienteil (13) die Sensorelektroden (4) enthält und in einem zweiten Folienteil (14) die elektrisch leitfähige dreidimensionale Schirmstruktur (5) enthält.

8. Haushaltsgerät nach Anspruch 6 oder 7, **dadurch gekennzeichnet, dass** das Folienelement (6) über eine Klebeschicht an einer Frontplatte (12) des kapazitiven Touchscreens (3) angebracht ist.

9. Haushaltsgerät nach einem der Ansprüche 1 bis 8, **dadurch gekennzeichnet, dass** die Bedienvorrichtung (2) ein Kunststoffgehäuse (15) enthält, welches den kapazitiven Touchscreen (3) und die elektrisch leitfähige dreidimensionale Schirmstruktur (5) derart umfasst, dass die elektrisch leitfähige dreidimensionale Schirmstruktur (5) das Gerätegehäuse (1) nicht berührt.

10. Haushaltsgerät nach einem der Ansprüche 1 bis 9, **dadurch gekennzeichnet, dass** die elektrisch leitfähige dreidimensionale Schirmstruktur (5) und der kapazitive Touchscreen (3) einen Winkel α im Bereich von 10° bis 90° bilden.

11. Haushaltsgerät nach einem der Ansprüche 1 bis 10, **dadurch gekennzeichnet, dass** eine elektrische Anbindung der dreidimensionalen Schirmstruktur (5) über einen Anschluss (16) erfolgt, über den auch die Anbindung des kapazitiven Touchscreens (3) an eine Auswerteelektronik erfolgt.

12. Haushaltsgerät nach einem der Ansprüche 1 bis 11, **dadurch gekennzeichnet, dass** das Potential, auf dem die elektrisch leitfähige dreidimensionale Schirmstruktur (5) liegt, ein vorgegebenes Wechselsignal ist oder ein vorgegebener fester Spannungspegel ist.

13. Haushaltsgerät nach einem der vorigen Ansprüche, **dadurch gekennzeichnet, dass** das Haushaltsgerät ein wasserführendes Haushaltsgerät ist, das ausgewählt ist aus der Gruppe bestehend aus Waschmaschine, Waschtrockner und Trockner.

14. Verfahren zur Herstellung eines Haushaltsgerätes mit einem Gerätegehäuse (1), einer Bedienvorrichtung (2) mit einem kapazitiven Touchscreen (3), umfassend Sensorelektroden (4), wobei der kapazitive Touchscreen (3) durch eine sich in das Geräteinnere erstreckende, an den kapazitiven Touchscreen (3) anschließende elektrisch leitfähige dreidimensionale Schirmstruktur (5) gegen elektromagnetische Strahlung abgeschirmt ist, und das Haushaltsgerät ein Folienelement (12) aufweist, das die Sensorelektroden (4) des kapazitiven Touchscreens (3) und die elektrisch leitfähige Schirmstruktur (5) enthält, wobei die elektrisch leitfähige dreidimensionale Schirmstruktur (5) mehrere Schirmelemente (7) beinhaltet, die sich an den kapazitiven Touchscreen (3) anschließen, so dass sie umlaufend um den kapazitiven Touchscreen (3) über dessen Rand geführt sind, der als Faltkante ausgebildet ist, so dass eine sich in das Geräteinnere erstreckende Schirmstruktur (5) gebildet werden kann, umfassend die Schritte:
(a) Bereitstellen eines Folienelementes (12), das die Sensorelektroden (4) des kapazitiven Touchscreens (3) und die elektrisch leitfähige Schirmstruktur (5) enthält;
(b) Anbringen des Folienelementes (12) an einer Frontplatte (16) des kapazitiven Touchscreens (3);
(c) Einstellen eines Winkels α zwischen der elektrisch leitfähigen Schirmstruktur (5) und dem Touchscreen (3) im Bereich von 10° bis 90°, wobei das Einstellen des Winkels α zwischen der elektrisch leitfähigen Schirmstruktur (5) und dem Touchscreen (3) durch ein Falten der Schirmelemente (7), die um den kapazitiven Touchscreen (3) herum angeordnet sind, entlang des Randes des kapazitiven Touchscreens (3) erfolgt;
(d) Einbringen von kapazitivem Touchscreen (3) und elektrisch leitfähiger Schirmstruktur (5) in das Gerätegehäuse.

## Claims

1. Household appliance with an appliance housing (1), an operating apparatus (2) with a capacitive touchscreen (3), comprising sensor electrodes (4), wherein the capacitive touchscreen (3) is shielded from electromagnetic radiation by an electrically conductive, three-dimensional shielding structure (5) that extends into the appliance interior and connects to the capacitive touchscreen (3), wherein the electrically conductive, three-dimensional shielding structure (5) contains a plurality of shielding elements (7), which connect to the capacitive touchscreen (3), so that they are guided peripherally around the capacitive touchscreen (3) over the edge thereof, which is embodied as a folding edge, so that a shielding structure (5) that extends into the appliance interior can be formed.

2. Household appliance according to claim 1, **characterised in that** the electrical, conductive, three-dimensional shielding structure (5) contains a metal and/or an electrically conductive organic metal.

3. Household appliance according to claim 2, **characterised in that** the metal is copper.

4. Household appliance according to one of claims 1 to 3, **characterised in that** the capacitive touchscreen (3) substantially forms a rectangle, the shielding elements (7) connecting to the four sides (8,9,10,11) thereof.

5. Household appliance according to claim 4, **characterised in that** the shielding elements (7) are embodied as rectangles.

6. Household appliance according to one of claims 1 to 5, **characterised in that** it has a film element (6), which contains the sensor electrodes (4) of the capacitive touchscreen (3) and/or the electrically conductive, three-dimensional shielding structure (5).

7. Household appliance according to claim 6, **characterised in that** the film element (6) contains the sensor electrodes (4) in a first film part (13) and the electrically conductive, three-dimensional shielding structure (5) in a second film part (14).

8. Household appliance according to claim 6 or 7, **characterised in that** the film element (6) is attached to a front plate (12) of the capacitive touchscreen (3) via an adhesive layer.

9. Household appliance according to one of claims 1 to 8, **characterised in that** the operating apparatus (2) contains a plastic housing (15), which comprises the capacitive touchscreen (3) and the electrically conductive, three-dimensional shielding structure (5) in such a way that the electrically conductive, three-dimensional shielding structure (5) does not touch the appliance housing (1).

10. Household appliance according to one of claims 1 to 9, **characterised in that** the electrically conductive, three-dimensional shielding structure (5) and the capacitive touchscreen (3) form an angle α in the range from 10° to 90°.

11. Household appliance according to one of claims 1 to 10, **characterised in that** an electrical joining of the three-dimensional shielding structure (5) takes place via a connection (16), via which the joining of the capacitive touchscreen (3) to an evaluation electronics unit takes place.

12. Household appliance according to one of claims 1 to 11, **characterised in that** the potential at which the electrically conductive, three-dimensional shielding structure (5) lies is a predefined alternating signal or a predefined fixed voltage level.

13. Household appliance according to one of the preceding claims, **characterised in that** the household appliance is a water-conducting household appliance, which is selected from the group consisting of washing machine, washer-dryer and dryer.

14. Method for producing a household appliance with an appliance housing (1), an operating apparatus (2) with a capacitive touchscreen (3), comprising sensor electrodes (4), wherein the capacitive touchscreen (3) is shielded from electromagnetic radiation by an electrically conductive, three-dimensional shielding structure (5) that extends into the appliance interior and connects to the capacitive touchscreen (3), and the household appliance has a film element (12), which contains the sensor electrodes (4) of the capacitive touchscreen (3) and the electrically conductive shielding structure (5), wherein the electrically conductive, three-dimensional shielding structure (5) contains a plurality of shielding elements (7), which connect to the capacitive touchscreen (3), so that they are guided peripherally around the capacitive touchscreen (3) over the edge thereof, which is embodied as a folding edge, so that a shielding structure (5) that extends into the appliance interior can be formed,
comprising the steps:
(a) providing a film element (12), which contains the sensor electrodes (4) of the capacitive touchscreen (3) and the electrically conductive shielding structure (5);
(b) attaching the film element (12) to a front plate (16) of the capacitive touchscreen (3);
(c) setting an angle α between the electrically conductive shielding structure (5) and the touchscreen (3) in the range from 10° to 90°, wherein the setting of the angle α between the electrically conductive shielding structure (5) and the touchscreen (3) takes place by folding the shielding elements (7), which are arranged around the capacitive touchscreen (3), along the edge of the capacitive touchscreen (3);
(d) introducing capacitive touchscreen (3) and electrically conductive shielding structure (5) into the appliance housing.

## Revendications

1. Appareil électroménager qui est muni d'un boîtier (1) pour l'appareil, d'un dispositif de commande (2) qui est équipé d'un écran tactile capacitif (3) qui comprend des électrodes de détection (4); dans lequel l'écran tactile capacitif (3) est protégé contre le rayonnement électromagnétique par l'intermédiaire d'une structure en trois dimensions (5) faisant office d'écran, de type électroconducteur, s'étendant jusqu'à l'intérieur de l'appareil, qui vient se raccorder à l'écran tactile capacitif (3) ; dans lequel la structure en trois dimensions faisant office d'écran, de type électroconducteur (5) comporte plusieurs éléments d'écran (7) qui se raccordent à l'écran tactile capacitif (3), d'une manière telle qu'ils sont guidés en direction périphérique autour de l'écran tactile capacitif (3) par-dessus le bord de ce dernier, qui est réalisé sous la forme d'une arête de pliage, tant et si bien que l'on peut former une structure faisant office d'écran (5) qui s'étend jusqu'à l'intérieur de l'appareil.

2. Appareil électroménager selon la revendication 1, **caractérisé en ce que** la structure en trois dimensions faisant office d'écran, de type électroconducteur (5) contient un métal et/ou un composé organométallique électroconducteur.

3. Appareil électroménager selon la revendication 2, **caractérisé en ce que** le métal est du cuivre.

4. Appareil électroménager selon l'une quelconque des revendications 1 à 3, **caractérisé en ce que** l'écran tactile capacitif (3) forme de manière essentielle un rectangle, aux quatre côtés duquel (8, 9, 10, 11) viennent se raccorder les éléments d'écran (7).

5. Appareil électroménager selon la revendication 4, **caractérisé en ce que** les éléments d'écran (7) sont réalisés sous la forme de rectangles.

6. Appareil électroménager selon l'une quelconque des revendications 1 à 5, **caractérisé en ce qu'**il présente un élément (6) sous la forme d'une feuille qui contient les électrodes de détection (4) de l'écran tactile capacitif (3) et/ou la structure en trois dimensions faisant office d'écran, de type électroconducteur (5).

7. Appareil électroménager selon la revendication 6, **caractérisé en ce que** l'élément (6) sous la forme d'une feuille contient, dans une première partie de la feuille (13) les électrodes de détection (4) et, dans une deuxième partie de la feuille (14), la structure en trois dimensions faisant office d'écran, de type électroconducteur (5).

8. Appareil électroménager selon la revendication 6 ou 7, **caractérisé en ce que** l'élément (6) sous la forme d'une feuille est appliqué par l'intermédiaire d'une couche adhésive contre une plaque avant (12) de l'écran tactile capacitif (3).

9. Appareil électroménager selon l'une quelconque des revendications 1 à 8, **caractérisé en ce que** le dispositif de commande (2) contient un logement en matière synthétique (15), qui englobe l'écran tactile capacitif (3) et la structure en trois dimensions faisant office d'écran, de type électroconducteur (5), d'une manière telle que la structure en trois dimensions faisant office d'écran, de type électroconducteur (5) n'entre pas en contact avec le boîtier (1) pour l'appareil.

10. Appareil électroménager selon l'une quelconque des revendications 1 à 9, **caractérisé en ce que** la structure en trois dimensions faisant office d'écran, de type électroconducteur (5) et l'écran tactile capacitif (3) forment un angle α qui se situe dans la plage de 10° à 90°.

11. Appareil électroménager selon l'une quelconque des revendications 1 à 10, **caractérisé en ce qu'**une connexion électrique de la structure en trois dimensions faisant office d'écran (5) a lieu par l'intermédiaire d'un raccord (16) au moyen duquel on obtient également la connexion de l'écran tactile capacitif (3) à une électronique d'exploitation.

12. Appareil électroménager selon l'une quelconque des revendications 1 à 11, **caractérisé en ce que** le potentiel que manifeste la structure en trois dimensions faisant office d'écran, de type électroconducteur (5), représente un signal alternatif qui a été prédéfini ou un niveau de tension fixe qui a été prédéfini.

13. Appareil électroménager selon l'une quelconque des revendications précédentes, **caractérisé en ce que** l'appareil électroménager représente un appareil électroménager du type à circulation d'eau, qui est choisi parmi le groupe constitué par un lave-linge, un lave-linge/sèche-linge et un sèche-linge.

14. Procédé destiné à la fabrication d'un appareil électroménager qui est muni d'un boîtier (1) pour l'appareil, d'un dispositif de commande (2) qui est équipé d'un écran tactile capacitif (3) qui comprend des électrodes de détection (4) ; dans lequel l'écran tactile capacitif (3) est protégé contre le rayonnement électromagnétique par l'intermédiaire d'une structure en trois dimensions (5) faisant office d'écran, de type électroconducteur, s'étendant jusqu'à l'intérieur de l'appareil, qui vient se raccorder à l'écran tactile capacitif (3) ; et l'appareil électroménager présente un élément (12) sous la forme d'une feuille qui contient les électrodes de détection (4) de l'écran tactile capacitif (3) et la structure en trois dimensions faisant office d'écran, de type électroconducteur (5) ; dans lequel la structure en trois dimensions faisant office d'écran, de type électroconducteur (5) comporte plusieurs éléments d'écran (7) qui se raccordent à l'écran capacitif (3), d'une manière telle qu'ils sont guidés en direction périphérique autour de l'écran tactile capacitif (3) par-dessus le bord de ce dernier, qui est réalisé sous la forme d'une arête de pliage, tant et si bien que l'on peut former une structure faisant office d'écran (5) qui s'étend jusqu'à l'intérieur de l'appareil,
qui comprend les étapes dans lesquelles :
(a) on procure un élément (12) sous la forme d'une feuille qui contient les électrodes de détection de l'écran tactile capacitif (3) et la structure (5) faisant office d'écran, de type électroconducteur ;
(b) on applique l'élément (12) sous la forme d'une feuille contre une plaque avant (16) de l'écran tactile capacitif (3) ;
(c) on règle un angle α formé entre la structure (5) faisant office d'écran, de type électroconducteur et l'écran tactile (3) dans la plage de 10° à 90° ; dans lequel le réglage de l'angle α formé entre la structure (5) faisant office d'écran, de type électroconducteur et l'écran tactile (3) a lieu par l'intermédiaire d'un pliage des éléments d'écran (7) qui sont disposés tout autour de l'écran tactile capacitif (3), le long du bord de l'écran tactile capacitif (3) ;
(d) on incorpore l'écran tactile capacitif (3) et la structure (5) faisant office d'écran, de type électroconducteur dans le boîtier pour l'appareil.
